# EUROPEAN PATENT APPLICATION

(11) **EP 4 783 234 A1**
(43) Date of publication of application: **29.07.2026**
(21) Application number: 24881403.0
(22) Date of filing: 09.10.2024
(51) Int. Cl.: H01L 21/768

(54) **PREPARATION METHOD FOR SEED CRYSTAL LAYER, METAL INTERCONNECTION PROCESS METHOD AND SEMICONDUCTOR PROCESS DEVICE**

(30) Priority: 24.10.2023 CN 202311386879
(71) Applicant: Beijing NAURA Microelectronics Equipment Co., Ltd., Beijing 100176 (CN)
(72) Inventor: ZHANG, Qintong, Beijing 100176 (CN)
(74) Representative: Cohausz & Florack
(86) International application number: PCT/CN2024/123580
(87) International publication number: WO 2025/087037

(57) **Abstract**

The present disclosure discloses a seed layer formation method, a metal interconnection process method, and semiconductor process equipment. The seed layer formation method includes: depositing a metal seed layer on a substrate having vias or trenches on a surface thereof, stopping deposition of the metal seed layer when openings of the vias or trenches are reduced to an extent that metal ions cannot enter the vias or trenches, oxidizing the surface of the substrate to transform the metal seed layer on the surface of the substrate and a portion of the metal seed layer at the openings of the vias or trenches into metal oxides, placing the substrate in a solution capable of dissolving the metal oxides to dissolve the metal oxides on the surface of the substrate and at the openings of the vias or trenches, thereby reopening the openings of the vias or trenches. The present disclosure enables increased seed layer coverage at the bottoms and sidewalls of vias or trenches, preventing voids from forming during subsequent metal electroplating.

## Description

### TECHNICAL FIELD

The present disclosure generally relates to the technical field of semiconductor manufacturing and, more particularly, to a seed layer formation method, a metal interconnection process method, and semiconductor process equipment.

### BACKGROUND

Metal interconnection technology in the back-end processes of integrated circuit chip manufacturing is one of the key technologies in chip manufacturing. With the continuous miniaturization of chip feature sizes, reliability issues caused by resistance-capacitance delay and electromigration in back-end metal interconnects have become major obstacles to improving chip performance. To improve the problems of RC delay and electromigration in chips, metal interconnect technology using the double damascene process has become mainstream approach. The common processes of the metal line double damascene process are as follows: forming vias or trenches in a dielectric thin film using photolithography, forming a barrier layer/metal seed layer using physical vapor deposition or chemical vapor deposition; electroplating metal to fill the vias or trenches, and chemical mechanical polishing to remove excess metal and expose the dielectric layer, thus realizing the circuitry needed by the chip.

However, with the continuous miniaturization of feature sizes, the aspect ratio of vias or trenches increases or remains constant while the feature size of the vias or trenches opening decreases. This dimensional variation poses a significant challenge to the deposition technology of barrier layers/metal seed layers. To address this miniaturization, the deposition technology of barrier layers/metal seed layers needs to cover vias or trenches with a large aspect ratio (greater than 2.5) and a small opening feature size (less than 50 nm), with a sufficiently thick barrier layer/metal seed layer (metal seed layer coverage greater than 50%), while simultaneously ensuring a sufficiently large opening (greater than 4 nm) to avoid voids in subsequent electroplating processes due to excessively small openings, which could affect the electrical performance or reliability of the chip. However, in actual industrial production, especially in advanced processes, it is difficult to simultaneously optimize both the vias or trenches opening size and the bottom coverage. Often, when the optimal bottom coverage is achieved, the vias or trenches opening size is very small, making it difficult to avoid voids in subsequent electroplating processes.

### SUMMARY

The purpose of the present disclosure is to provide a seed layer formation method, a metal interconnection process, and semiconductor process equipment, thereby improving the seed layer coverage at the bottoms and sidewalls of vias or trenches, while ensuring that the vias or trenches have opening sizes sufficient for subsequent electroplating of filling metal, thus avoiding metal voids during the subsequent electroplating process.

In a first aspect, the present disclosure provides a metal seed layer formation method, including:
depositing a metal seed layer on a substrate having vias or trenches on the surface thereof, stopping the deposition of the metal seed layer when openings of the vias or trenches are reduced to an extent that metal ions cannot enter the vias or trenches;
oxidizing the surface of the substrate to transform the metal seed layer on the surface of the substrate and a portion of the metal seed layer at the openings of the vias or trenches into metal oxides;
placing the substrate in a solution capable of dissolving metal oxides to dissolve the metal oxides on the surface of the substrate and at the openings of the vias or trenches, thereby reopening the openings of the vias or trenches.

In some embodiments, depositing the metal seed layer on the substrate having vias or trenches on the surface thereof further includes:
forming a diffusion barrier layer on the substrate, the diffusion barrier layer covering the surface of the substrate and the bottoms and sidewalls of the vias or trenches;
the metal seed layer is deposited on the diffusion barrier layer.

In some embodiments, oxidizing the surface of the substrate includes:
introducing an oxidizing gas and an inert gas into a process chamber, and exciting the oxidizing gas into plasma;
bombarding the surface of the substrate with the plasma of the oxidizing gas, thereby transforming the metal seed layer at the openings of the vias or trenches into the metal oxides.

In some embodiments, the oxidizing gas includes at least one of oxygen, ozone, and nitrogen dioxide.

In some embodiments, the solution capable of dissolving the metal oxides includes an acidic solution and a corresponding metal salt of the acid, the acidic solution including sulfuric acid solution, nitric acid solution, and acidic chloride salt solution.

In some embodiments, when the openings of the vias or trenches are reduced to a size that prevents metal ions from entering the vias or trenches, the size of the vias or trenches opening ranges from 0 nm to 4 nm.

In some embodiments, after the openings on tops of the vias or trenches are opened, the size of the openings of the vias or trenches is greater than 4 nm.

In some embodiments, the material of the metal seed layer includes at least one of Cu, Co, and Ru.

In some embodiments, the material of the diffusion barrier layer includes at least one of TaN, Ta, Co, Ru, and TiN.

In some embodiments, the material of the metal seed layer is Cu, and the process parameters for oxidizing the surface of the substrate include:
process chamber pressure range: 1 mTorr to 10 Torr;
plasma excitation power range: 500 W to 3 KW;
bias power range: 0 W to 1800 W.

In some embodiments, before depositing the metal seed layer on the substrate with vias or trenches on the surface, the method further includes:
degassing the substrate to remove volatile impurities from the surface of the substrate; and/or
plasma pre-cleaning the substrate to remove residues from the surface of the substrate and within the vias or trenches.

In a second aspect, the present disclosure proposes a metal interconnection process method, including: providing the substrate obtained using the metal seed layer fabrication method described in the first aspect; and filling the vias or trenches in the substrate with metal through an electroplating process to form metal interconnects.

In a third aspect, the present disclosure proposes semiconductor process equipment, including a plurality of process chambers and a controller, the controller comprising at least one processor and at least one memory, the memory storing a computer program, the computer program being executed by the processor to implement the metal seed layer fabrication method described in the first aspect.

The beneficial effects of the present disclosure are as follows:
The method for preparing the metal seed layer in the present disclosure, when depositing the metal seed layer onto the bottoms and sidewalls of the vias or trenches, selects to stop depositing the metal seed layer only when the opening at the top of the vias or trenches is reduced to an extent that when copper ions can no longer enter the vias or trenches. That is, the present disclosure adopts a strategy that prioritizes ensuring the coverage of the bottoms and sidewalls, continuously increasing the seed layer coverage of the bottoms and sidewalls of the vias or trenches until the opening is nearly closed or completely closed, without needing to compromise on the minimum opening value. This achieves a higher bottom and sidewall coverage. Subsequently, by performing an oxidation treatment on the surface of the substrate, part of the metal seed layer at the top openings of the vias or trenches is transformed into metal oxides, and then a solution capable of dissolving the metal oxides is used to dissolve the metal oxides at the top openings of the vias or trenches, thereby reopening the opening at the top of the via or trench. This method allows for a higher metal seed layer coverage on the bottoms and sidewalls of the vias or trenches while ensuring an opening size sufficient for electroplating metal filling. Because the metal seed layer coverage on the bottoms and sidewalls of the vias or trenches is higher, the remaining space within the vias or trenches to be filled with metal is smaller. Therefore, even with a small opening, void-free metal filling can be achieved during subsequent electroplating, effectively avoiding the problem of metal voids in subsequent electroplating processes.

The system of the present disclosure has other features and advantages, which will be apparent from the accompanying drawings and detailed descriptions incorporated herein by reference, or will be set forth in detail in the accompanying drawings and detailed descriptions, which together serve to explain the specific principles of the present disclosure.

### BRIEF DESCRIPTION OF THE DRAWINGS

The above and other objects, features, and advantages of the present disclosure will become more apparent from the more detailed description of exemplary embodiments of the present disclosure taken in conjunction with the accompanying drawings, in which the same reference numerals generally represent the same components.
FIG. 1 shows a schematic diagram of voids generated during electroplating due to excessively small openings in vias or trenches in existing metal seed layer fabrication processes.
FIG. 2 shows a schematic diagram of voids generated during electroplating due to insufficient bottom coverage in vias or trenches in existing metal seed layer fabrication processes.
FIG. 3 shows a schematic diagram of achieving void-free metal filling by selecting a relatively stable compromise value within a process window in existing metal seed layer fabrication processes.
FIG. 4 shows a flowchart of a metal seed layer fabrication method according to the present disclosure.
FIG. 5 shows a schematic diagram of metal seed layer formation in a metal seed layer fabrication method according to an embodiment of the present disclosure.
FIG. 6 shows a schematic diagram of the metal seed layer after oxidation treatment in a metal seed layer fabrication method according to an embodiment of the present disclosure.
FIG. 7 shows a schematic diagram of reopening the opening after dissolving the metal oxides in a metal seed layer fabrication method according to an embodiment of the present disclosure.
FIG. 8 shows a schematic diagram of metal interconnection fabrication using a metal interconnection process according to an embodiment of the present disclosure.
FIG. 9 shows a schematic diagram of semiconductor process equipment according to an embodiment of the present disclosure.

### DETAILED DESCRIPTION OF THE EMBODIMENTS

The existing process flow for dual damascene metal interconnects is as follows: First, vias or trenches are formed in a dielectric thin film using photolithography. Then, a barrier layer/metal seed layer with good process coverage is deposited using physical vapor deposition. Next, the vias or trenches are filled using electroplating. Finally, excess metal is removed by chemical mechanical polishing.

In the process of preparing the barrier layer/metal seed layer, physical vapor deposition or a combination of physical vapor deposition and chemical vapor deposition (including atomic layer deposition) is commonly used. Once the wafer enters the processing equipment, the wafer first undergoes degassing and plasma pre-cleaning to ensure that the oxide layer covering the preceding metal lines and any residues from trenching or drilling etching and cleaning processes are completely removed before the deposition process. This strengthens the bonding strength between layers and reduces the resistance between interconnecting metal lines. Next, a barrier layer is prepared using physical vapor deposition or a combination of physical vapor deposition and chemical vapor deposition (including atomic layer deposition) to prevent the diffusion of metal elements from the corresponding metal seed layer and improve the adhesion of the metal seed layer. This metal seed layer is then prepared using physical vapor deposition and serves as the seed for subsequent metal electroplating processes. Process integration requires a large bottom and sidewall coverage and a large opening feature size to prevent metal voids caused by premature closure of the opening during subsequent metal electroplating.

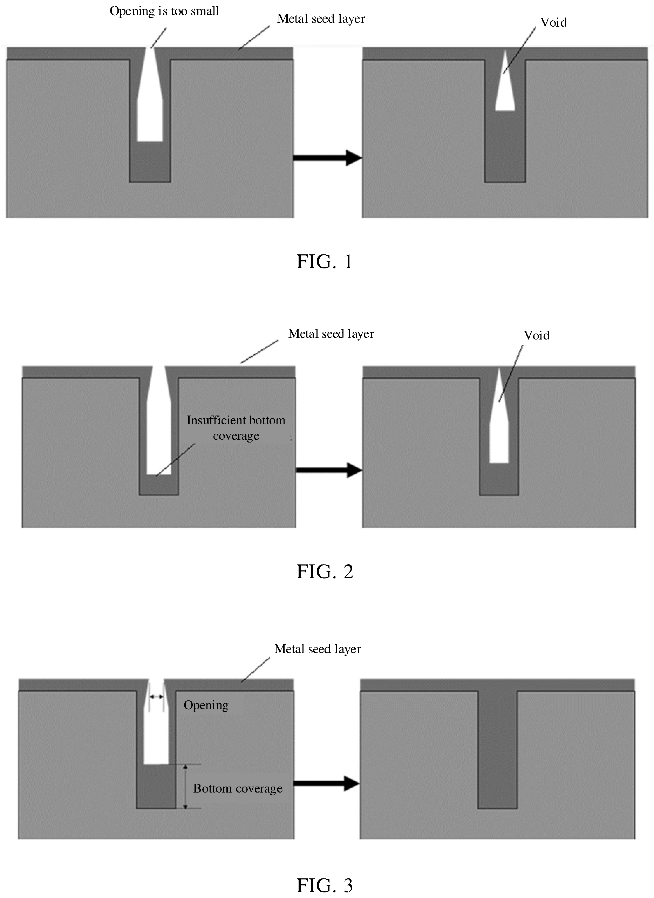

To address the miniaturization trend, the barrier layer/seed layer deposition technique needs to cover sufficiently thick barrier layers/seed layers in vias or trenches with a large aspect ratio and small opening feature size, while simultaneously ensuring a large opening size. As shown in FIGs. 1 and 2, if the opening is too small (FIG. 1) or the coverage is insufficient (FIG. 2), voids may occur in subsequent metal electroplating processes.

However, in actual industrial production, especially in advanced processes, it is difficult to simultaneously optimize both the opening size and bottom coverage. Often, a relatively stable compromise value within a process window is needed to achieve void-free filling, as shown in FIG. 3. Generally, when the bottom coverage is optimal, the size of the vias or trenches opening is very small.

The present disclosure proposes a seed layer formation method, a metal interconnection process method, and semiconductor process equipment that can achieve a seed layer process with high bottom coverage and a good opening, avoiding the generation of metal voids during subsequent metal electroplating filling.

The present disclosure will now be described in more detail with reference to the accompanying drawings. Although preferred embodiments of the present disclosure are shown in the drawings, it should be understood that the present disclosure can be implemented in various forms and should not be limited to the embodiments set forth herein. Rather, the embodiments are provided to make the present disclosure more thorough and complete, and to fully convey the scope of the present disclosure to those skilled in the art.

### Embodiment 1

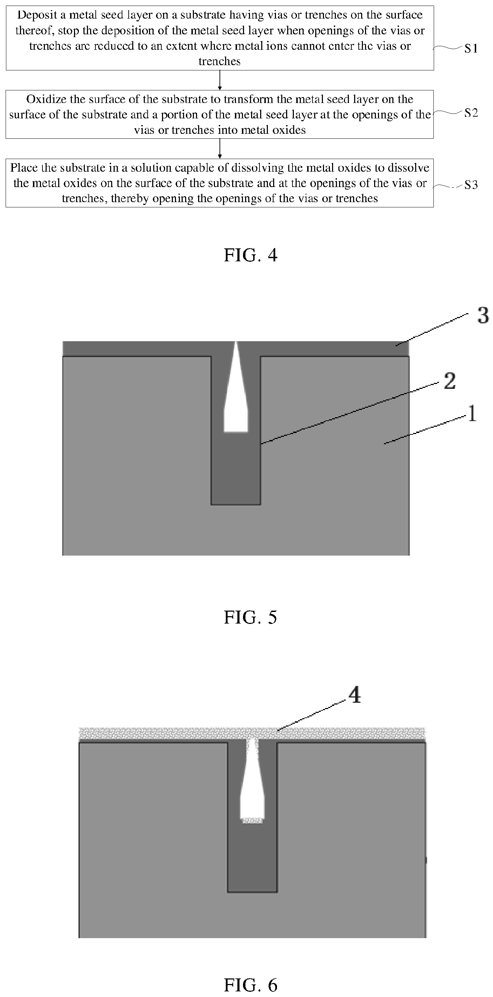

FIG. 4 shows a flowchart of a metal seed layer formation method according to the present disclosure.

As shown in FIG. 4, and in conjunction with FIGs. 5 to 8, this embodiment provides a metal seed layer formation method, including:
S1: Depositing a metal seed layer 3 on a substrate 1 having vias or trenches on the surface thereof, stopping the deposition of the metal seed layer 3 when openings of the vias or trenches are reduced to an extent where metal ions cannot enter the vias or trenches;

Specifically, during the deposition of the metal seed layer 3, the metal deposition rate at the top openings of the vias or trenches is greater than the metal deposition rate at the sidewalls of the vias or trenches.

The substrate 1 is a substrate (e.g., a wafer) that has undergone front-end processing. The substrate 1 may include devices such as transistors. The vias or trenches on the surface of the substrate 1 are formed by an etching process, forming openings on the surface of the substrate 1. The vias or trenches may be formed in a dielectric layer between adjacent metal layers for subsequent metal interconnection to achieve electrical connections between devices, between devices and metal layers, or between adjacent metal layers.

The material of the metal seed layer 3 includes at least one of Cu, Co, and Ru; this embodiment uses Cu as the material of the metal seed layer 3 for illustration.

Preferably, before performing process S1, the method further includes:
S01: Degassing the substrate 1 to remove volatile impurities from its surface; and/or performing plasma pre-cleaning on the substrate 1 to remove residues from its surface and within vias or trenches.

Specifically, after the substrate 1 is introduced into the process equipment, degassing and/or plasma pre-cleaning are first performed to ensure that the oxide layer covering the front-end metal lines, and residues from vias or trenches etching and cleaning process are completely removed before the deposition process. This strengthens the metal bonding strength between layers and reduces the resistance between interconnect copper lines. The degassing process involves heating the wafer to remove volatile impurities such as water vapor adsorbed on the wafer's surface, preventing volatile impurities from affecting subsequent processes. This can be accomplished through a degassing process chamber. Plasma pre-cleaning involves removing residues from front-end processes on substrate 1 by reacting plasma with the oxide layer on the metal lines and residues within vias or trenches (or through plasma bombardment). The plasma pre-cleaning process can be performed in a plasma pre-cleaning chamber.

In this embodiment, before process S1, the method further includes:
S02: Forming a diffusion barrier layer 2 on substrate 1, covering the surface and the bottoms and sidewalls of vias or trenches of the substrate 1; depositing the metal seed layer 3 on the diffusion barrier layer 2;
The diffusion barrier layer 2 includes at least one of the following materials: TaN, Ta, Co, Co and Ru, Co-doped Ru, or Ru-doped Co, RuTa, Ru, and TiN.

Specifically, the diffusion barrier layer 2 is used to block the diffusion of metal elements in the metal seed layer 3 and improve the adhesion of the metal seed layer 3. In this embodiment, to block the diffusion of copper element, the diffusion barrier layer 2 can be a TaN/Ta composite film, a TaN/Ta/Co composite film, a TaN/Co composite film or a TaN/Ru composite film, a TaN/Co/Ru, a TaN/Ru(Co), or a TaN/RuTa. Taking the preparation of the diffusion barrier layer 2 of the TaN/Ta composite film as an example, firstly, a TaN thin film is deposited on the surface of the substrate 1 to cover the surface of the substrate 1 and the bottoms and sidewalls of the vias or trenches, and then a Ta thin film is deposited on top of the TaN thin film to form a TaN/Ta composite diffusion barrier layer 2. The diffusion barrier layer 2 can be prepared using a process chamber for preparing barrier layers, and can be prepared using physical vapor deposition or a combination of physical vapor deposition and chemical vapor deposition (including atomic layer deposition).

In other embodiments, when the material of the metal seed layer 3 is Co, the material of the diffusion barrier layer 2 can be TiN. When the material of the metal seed layer 3 is Ru, due to the low diffusivity of Ru, the diffusion barrier layer 2 can be omitted, i.e., process S02 can be skipped, and the process proceeds directly to the subsequent process S2. Furthermore, process S01, i.e., the degassing treatment and/or plasma pre-cleaning treatment, can be performed before process S02.

In process S1, the metal seed layer 3 serves as the seed for subsequent metal electroplating processes. The metal seed layer 3 can be prepared using a physical vapor deposition process, completed in a metal seed layer 3 process chamber. It should be noted that when the size of the openings of the vias or trenches is reduced to a level where metal ions cannot enter the via or trench, the size of the corresponding vias or trenches opening can be selected within the range of 0 nm to 4 nm.

In this embodiment, preferably, the deposition of the metal seed layer 3 is stopped when the size of the vias or trenches opening is less than 4 nm, i.e., when the openings of the vias or trenches are nearly closed. More preferably, the deposition of the metal seed layer 3 is stopped when the size of the vias or trenches opening is 0 nm, i.e., when the openings of the vias or trenches are completely closed, thereby ensuring the highest bottom coverage.

The structure after the deposition of the metal seed layer 3 in process S1 is shown in FIG. 5. Process S1 is an important improvement of the present disclosure, as process S1 changes the currently commonly used process strategy for the metal seed layer 3. Specifically, the currently commonly used strategy is: during the deposition of the metal seed layer 3, it is needed to ensure that the opening size is at least greater than a certain value (e.g., 4 nm or larger), i.e., to stop the deposition of the metal seed layer 3, so that the bottom process coverage reaches a relatively maximum, for example, exceeding 50%. The process strategy for preparing the metal seed layer 3 in the present disclosure is as follows: Prioritize ensuring the seed layer coverage at the bottoms and sidewalls of the vias or trenches, continuously increasing the coverage until the openings are nearly or completely closed (compared to existing metal seed layer 3 processes, this method does not need a compromise on the minimum opening size). Deposition of the metal seed layer 3 stops only when no more copper ions can enter the vias or trenches, thus achieving a higher bottom coverage and expanding the process window for preparing the metal seed layer 3 compared to existing processes.

S2: Oxidizing the surface of the substrate 1, transforming the metal seed layer 3 on the substrate 1 surface and a portion of the metal seed layer 3 at the vias or trenches openings into metal oxides 4.

This process specifically includes:
Introducing an oxidizing gas and an inert gas into the process chamber, and exciting the oxidizing gas into plasma;
Bombarding the surface of the substrate 1 with the plasma of the oxidizing gas to transform the metal seed layer 3 at the vias or trenches openings into metal oxides 4.

In some embodiments, the oxidizing gas includes at least one of oxygen, ozone, and nitrogen dioxide. Oxygen is preferred in this embodiment. In other embodiments, when the material of the metal seed layer 3 is Co or Ru, the oxidizing gas can be ozone, nitrogen dioxide, or a combination of ozone and nitrogen dioxide having stronger oxidizing properties.

Preferably, the process parameters for the oxidation treatment of the copper seed layer in this process include:
Process chamber pressure range: 1 mTorr to 10 Torr;
Plasma excitation power range: 500 W to 3 KW;
Bias power range: 0 W to 1800 W.

Specifically, this process can be completed using a newly added post-processing chamber. After the substrate 1 enters the post-processing chamber, the substrate 1 is placed on a heater or electrostatic chuck, and an oxidizing gas and an inert gas are introduced for ignition. The inert gas is preferably argon. The chamber pressure range is preferably 1 mTorr to 10 Torr. The typical process time is between 5 s and 120 s. The plasma excitation method for the oxidizing gas can be selected from ICP, CCP, or RPS. In this embodiment, oxygen plasma is excited above substrate 1, with an excitation power preferably ranging from 500W to 3KW. The falling speed and angle of oxygen ions are controlled by applying a bias voltage, with the applied bias voltage preferably ranging from 0W to 1000W. The high-energy oxygen ions bombard the copper seed layer on the surface of substrate 1, causing copper seed layer to oxidize. The thickness of the metal oxides 4 is increased or decreased by controlling the process time according to specific needs. Oxygen plasma will also oxidize the metal seed layers at the top of near-closed or completely closed vias or trenches, as shown in FIG. 6.

The post-processing chamber introduced in this process uses plasma of oxidizing gas to oxidize the metal seed layer 3 on the surface of near or completely closed vias or trenches, causing metal seed layer 3 to oxidize. The purpose of oxidation is to oxidize the metal seed layer on the surface of substrate 1 and the metal seed layer at the vias or trenches into metal oxides 4, providing a basis for subsequently reopening the openings at the top of vias or trenches.

S3: Substrate 1 is placed in a solution capable of dissolving the metal oxides 4, causing the metal oxides 4 at the top openings of vias or trenches to dissolve, thereby reopening the openings of the vias or trenches.

The solutions capable of dissolving the metal oxides 4 include acidic solutions and corresponding metal salt of the acids. Acidic solutions include sulfuric acid solutions, nitric acid solutions, and acidic chloride salt solutions (such as copper chloride solutions, aluminum chloride solutions, zinc chloride solutions, etc.).

After this process, the size of the opening after the vias or trenches is opened is preferably greater than 4 nm.

Specifically, this process involves opening the nearly closed or completely closed openings of the vias or trenches. In this process, the substrate 1 is immersed in a solution capable of reacting with the metal oxides 4. The solution dissolves the metal oxides 4 on the surface and at the top openings of the vias or trenches of the substrate 1, thereby opening the vias or trenches to facilitate subsequent copper electroplating to fill the via or trench.

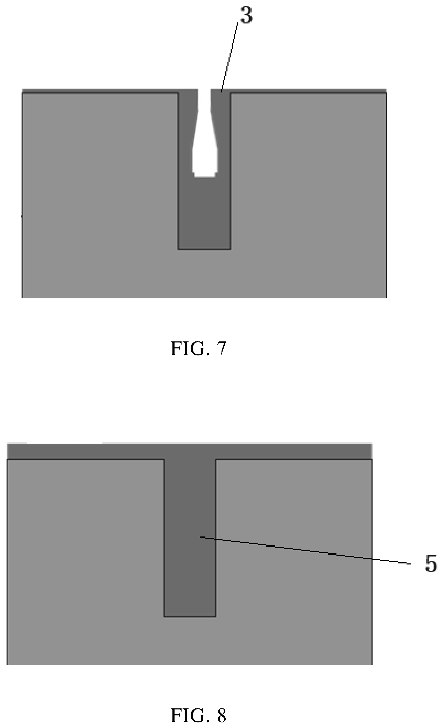

In this embodiment, a copper plating solution is preferably used. The copper plating solution contains a large amount of sulfuric acid (H₂SO₄), copper sulfate (CuSO₄), and reducing components. The copper plating solution can react with the metal oxides 4 (i.e., copper oxide) on the surface and at the top openings of the vias or trenches of the substrate 1. Generally, copper oxide can be dissolved in less than 5 seconds. That is, after the substrate 1 has been immersed in the copper plating solution for a period of time, the openings of the vias or trenches that were nearly or completely closed will be reopened, as shown in FIG. 7. Simultaneously, the copper plating solution can be utilized to integrate the process of reopening the openings of the vias or trenches with the subsequent copper plating process into a single process. The opening process is completed simultaneously with the copper plating process. That is, during the copper plating process, the substrate 1 is placed in the plating solution for a period of time, such as 4-10 seconds, until the openings of the vias or trenches open, and then the copper plating process is performed directly. This eliminates the need for additional dissolution processes and related materials, improving process efficiency and reducing process costs.

Since process S1 can maximize the coverage of the metal seed layer 3 at the bottoms and sidewalls of the vias or trenches, the voids within the vias or trenches that need electroplating metal filling will be smaller. Therefore, by using processes S2 and S3 to open even a small opening, it is sufficient to ensure that the electroplated metal can completely fill the remaining space within the vias or trenches, thus preventing voids from forming during subsequent metal electroplating.

### Embodiment 2

This embodiment provides a metal interconnection process method, including:
providing the substrate obtained using the metal seed layer formation method of Embodiment 1;
filling the vias or trenches of the substrate with metal through an electroplating process to form metal interconnects 5.

The substrate structure obtained using the method of Embodiment 1, as shown in FIG. 7, has a higher coverage of the bottoms and sidewalls of the vias or trenches on the substrate and has an opening sufficient for electroplating filling metal. Therefore, directly electroplating this substrate can effectively avoid the problem of voids forming during metal electroplating, resulting in better electrical connection of the metal interconnects 5, as shown in FIG. 8.

The electroplated metal material includes at least one of Cu, Co, and Ru. In this embodiment, the electroplated metal is Cu, and the electroplated metal interconnection 5 is a copper interconnect.

### Embodiment 3:

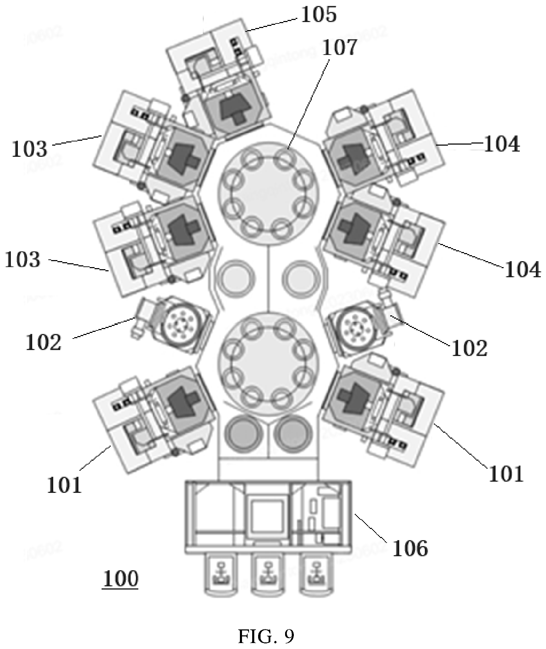

FIG. 9 shows a schematic diagram of semiconductor process equipment according to an embodiment of the present disclosure.

As shown in FIG. 9, this embodiment provides semiconductor process equipment 100, including multiple process chambers and a controller (not shown). The controller includes at least one processor and at least one memory. The memory stores a computer program that, when executed by the processor, implements the metal seed layer formation method of Embodiment 1.

The multiple process chambers include at least one degassing process chamber 102, at least one pre-cleaning process chamber 101, at least one barrier layer process chamber 103, at least one seed layer process chamber 104, and at least one post-processing process chamber 105. In this embodiment, there are two degassing process chambers 102, two pre-cleaning process chambers 101, two barrier layer process chambers 103, and two seed layer process chambers 104, and one post-processing process chamber 105.

The degassing chamber 102 is used for heating the wafer to remove volatile impurities from the wafer surface; the pre-cleaning chamber 101 is used for plasma pre-cleaning the wafer to remove residues from its surface and within vias or trenches; the barrier layer chamber 103 is used for depositing a diffusion barrier layer 2 on the wafer; the seed layer chamber 104 is used for depositing a metal seed layer 3 on the wafer; and a post-processing chamber 105 is used for oxidizing the wafer surface, transforming a portion of the metal seed layer 3 into metal oxides 4.

In this embodiment, the semiconductor process equipment 100 also includes a wafer box storage cabinet 106, a wafer transport mechanism 107, and a wafer transport chamber connecting to each process chamber.

Exemplarily, the controller can be a host computer or a slave computer. The controller can control the wafer transport mechanism 107 to transport the wafer to be processed between the process chambers, and can also control each process chamber to complete the corresponding process in the seed layer formation method of Embodiment 1.

The embodiments of the present disclosure have been described above. These descriptions are exemplary and not exhaustive, nor are they limited to the disclosed embodiments. Many modifications and variations will be apparent to those skilled in the art without departing from the scope and spirit of the described embodiments.

## Claims

1. A metal seed layer formation method comprising:
depositing a metal seed layer on a substrate having vias or trenches on a surface thereof, stopping deposition of the metal seed layer when openings of the vias or trenches are reduced to an extent that metal ions cannot enter the vias or trenches;
oxidizing the surface of the substrate to transform the metal seed layer on the surface of the substrate and a portion of the metal seed layer at the openings of the vias or trenches into metal oxides;
placing the substrate in a solution capable of dissolving the metal oxides to dissolve the metal oxides on the surface of the substrate and at the openings of the vias or trenches, thereby reopening the openings of the vias or trenches.

2. The metal seed layer formation method according to claim 1, wherein, before depositing the metal seed layer on the substrate having the vias or trenches on the surface thereof, the method further includes:
forming a diffusion barrier layer on the substrate, the diffusion barrier layer covering the surface of the substrate and bottoms and sidewalls of the vias or trenches;
the metal seed layer being deposited on the diffusion barrier layer.

3. The metal seed layer formation method according to claim 1, wherein, oxidizing the surface of the substrate includes:
introducing an oxidizing gas and an inert gas into a process chamber, and exciting the oxidizing gas into plasma;
bombarding the surface of the substrate with the plasma of the oxidizing gas, thereby transforming the metal seed layer at the openings of the vias or trenches into the metal oxides.

4. The metal seed layer formation method according to claim 3, wherein, the oxidizing gas includes at least one of oxygen, ozone, and nitrogen dioxide.

5. The metal seed layer formation method according to claim 1, wherein, the solution capable of dissolving the metal oxides includes an acidic solution and a corresponding metal salt of the acid, the acidic solution including a sulfuric acid solution, a nitric acid solution, and an acidic chloride salt solution.

6. The metal seed layer formation method according to claim 1, wherein, when the openings of the vias or trenches are reduced to the extent that the metal ions cannot enter the vias or trenches, a size of the openings of the vias or trenches is in a range of 0 nm to 4 nm.

7. The metal seed layer formation method according to claim 1, wherein, after the openings on tops of the vias or trenches are opened, the size of the openings of the vias or trenches is greater than 4 nm.

8. The metal seed layer formation method according to any one of claims 1-7, wherein, a material of the metal seed layer includes at least one of Cu, Co, and Ru.

9. The metal seed layer formation method according to claim 2, wherein, a material of the diffusion barrier layer includes at least one of TaN, Ta, Co, Co and Ru composite, Co-doped Ru, Ru-doped Co, RuTa, Ru and TiN.

10. The metal seed layer formation method according to claim 1, wherein a material of the metal seed layer is Cu, and process parameters for oxidizing the surface of the substrate include:
process chamber pressure range: 1 mTorr to 10 Torr;
plasma excitation power range: 500 W to 3 KW;
bias power range: 0 W to 1800 W.

11. The metal seed layer formation method according to claim 1, wherein, before depositing the metal seed layer on the substrate with vias or trenches on the surface, the method further includes:
degassing the substrate to remove volatile impurities from the surface of the substrate; and/or
plasma pre-cleaning the substrate to remove residues from the surface of the substrate and within the vias or trenches.

12. A metal interconnection process method comprising:
providing the substrate obtained using the metal seed layer formation method according to any one of claims 1-11;
filling the vias or trenches of the substrate with metal by an electroplating process to form metal interconnects.

13. Semiconductor process equipment, comprising a plurality of process chambers and a controller, wherein the controller includes at least one processor and at least one memory, the memory storing a computer program, the computer program being executed by the processor to implement the metal seed layer formation method according to any one of claims 1-11.
